# EUROPEAN PATENT APPLICATION

(11) **EP 1 755 367 A2**
(43) Date of publication of application: **21.02.2007**
(21) Application number: 06024551.1
(22) Date of filing: 08.11.2000
(51) Int. Cl.: H05K 3/34, H01L 23/498

(54) **Surface mounting component and mounted structure of surface mounting component**

(30) Priority: 25.11.1999 JP 33375499
(62) Divisional of application: 00124434.2
(71) Applicant: MURATA MANUFACTURING CO., LTD., Nagaokakyo-shi Kyoto-fu 617-8555 (JP)
(72) Inventor: Oida, Toshifumi, Nagaokakayo-shi Kyoto-fu, 617-8555 (JP); Ochii, Akihiro, Nagaokakayo-shi Kyoto-fu, 617-8555 (JP); Okuda, Nobuyoshi, Nagaokakayo-shi Kyoto-fu, 617-8555 (JP); Satou, Yoshihirou, Nagaokakayo-shi Kyoto-fu, 617-8555 (JP); Fujikawa, Katsuhiko, Nagaokakayo-shi Kyoto-fu, 617-8555 (JP)
(74) Representative: Schoppe, Fritz

(57) **Abstract**

A surface mounting component (51) to be surface-mounted onto a mounting board by soldering comprises an isolated electrode (35) to be soldered to the mounting board and arranged on a mounting-surface (32) of the surface mounting component (51) so as to be isolated from other terminal electrodes (34), wherein the terminal electrodes (34) are arranged so as to surround the isolated electrode (35) on the mounting-surface, and wherein the single isolated electrode (35) per se takes an unsymmetrical shape to have a directional discriminating function or is provided unsymmetrically with respect to the mounting-surface to have a directional discriminating function.

## Description

### BACKGROUND OF THE INVENTION

### 1. Field of the Invention

The present invention relates to a surface mounting component, and more particularly to a surface mounting component for which a means for enhancing the bonding strength of the surface mounting component to a mounting board in the state that the part is mounted to the mounting board is provided.

### 2. Description of the Related Art

Surface mounting components are soldered to mounting boards by surface-mounting. As a surface mounting components, a multilayered component having a multilayer structure is exemplified. In most of multilayered components, surface-mounting is carried out on a motherboard as a mounting board.

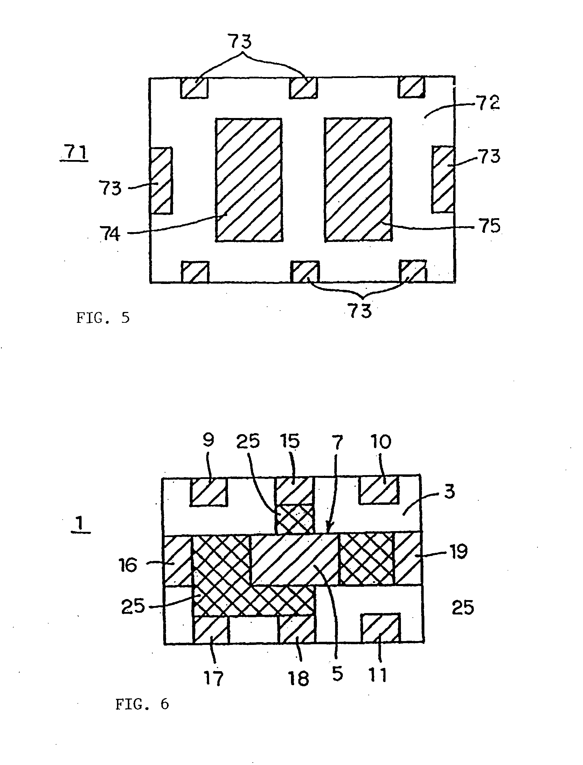

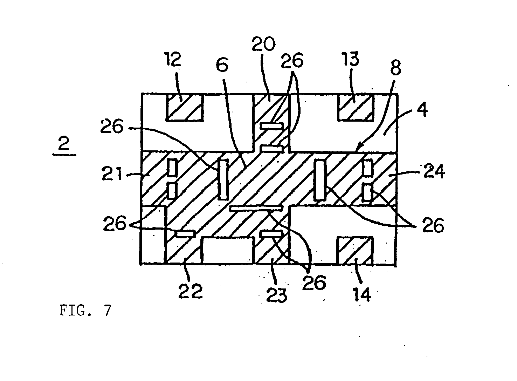

FIGS. 6 and 7 show mounting-surfaces 3 and 4 which are on the back sides, namely, on the motherboard (not shown) side of multilayered components 1 and 2, respectively, which are relevant to the present invention.

Referring to FIGS. 6 and 7, a means for enhancing the bonding strength of the multilayered components 1 and 2 to the motherboards in the state that the motherboards 1 and 2 are mounted to the motherboards, respectively, is provided. In particular, electrode portions 5 and 6 are positioned substantially in the centers of the mounting-surfaces 3 and 4, respectively. The electrode portions 5 and 6 are soldered to the motherboards, and thereby, the bonding strength is enhanced.

The above-described electrode portions 5 and 6 are provided not exclusively for enhancement of the bonding strength. That is, particular terminal electrodes for electrical use in the multilayered components 1 and 2 constitute the electrode portion 5 and 6, respectively. Ordinarily, in many cases, the electrode portions 5 and 6 are formed by use of a part of ground terminal electrodes 7 and 8, respectively.

On the multilayered components 1 and 2, some terminals 9 to 11 and 12 to 14 for signals or the like are provided on the multilayered components 1 and 2, in addition to the above-mentioned ground terminal electrodes 7 and 8. In some cases, these terminals electrodes 7 to 14 have extensions which are extended to the side faces adjacent to the mounting-surface 3 and 4.

The above-described ground terminal electrodes 7 and 8 are formed on relatively wide areas in the mounting-surfaces 3 and 4. When the multilayered components 1 and 2 are surface-mounted onto the motherboards by soldering, all of the areas of the ground terminal electrodes 7 and 8 are not soldered, but soldering areas are limited e.g., to the end portions 15 to 19 and the center electrode portions 5 and 6 in the ground terminal electrodes 7 and 8, so that the consumption amount of solder is limited. For this purpose, the following means is provided in each of the multilayered components 1 and 2.

In the multilayered component 1 shown in FIG. 6, solder resist films 25 made from glass glaze or the like are formed on the cross-hatched areas in the ground terminal electrode 7 shown in FIG. 6 with only the central electrode portion 5 and the end portions 15 to 19 being exposed.

On the other hand, in the multilayered component 2 shown in FIG. 7, slits 26 are formed so as to section the electrode portion 6 and the end portions 20 to 24 of the ground terminal electrode 8, individually.

For the multilayered component 1 shown in FIG. 6, a process of forming the solder resist films 25 is needed. This rises the cost of the multilayered component 1. Furthermore, the bonding strength of the solder resist films 25 to the ground terminal electrode 7 at the interface is relatively low. Therefore, in some cases, deficiencies such as release of the solder resist films 25 are generated.

In the multilayered component 2 shown in FIG. 7, first, there arises the problem that it is very difficult for the slits 26 to prevent solder from flowing out completely. Moreover, for printing by which the ground terminal electrode 8 is formed, a high fineness is required, since the slits 26 are formed. The shape and size of the slits 26 tend to become deficient, caused by scratchy printing or blotting.

Furthermore, in either of the multilayered component 1 shown in FIG. 6 and the multilayered component 2 shown in FIG. 7, respectively, the areas of the ground terminal electrodes 7 and 8 are large. Therefore, in some cases, the ratios of the areas of the electrodes 7 and 8 to the inner conductor films formed inside of the multilayered components 1 and 2 are mismatched, which causes distortion of the multilayered components 1 and 2 during the manufacturing process.

Heretofore, with respect to the multilayered components as examples of the surface mounting component, problems to be solved have been described. Other surface mounting components may encounter such problems as described above.

### SUMMARY OF THE INVENTION

Accordingly, it is an object of the present invention to provide a surface mounting component which can solve the above-described problems.

To achieve the object, according to the present invention, there is provided a surface mounting component to be surface-mounted onto a mounting board by soldering, which includes an isolated electrode to be soldered to the mounting board, arranged on a mounting-surface of the surface mounting component so as to be insolated from other terminal electrodes on the mounting-surface.

Preferably, the isolated electrode per se takes an unsymmetrical shape, or is arranged unsymmetrically with respect to the mounting-surface to have a directional discriminating function.

Also preferably, the surface mounting component is a multilayered component, the multilayered component is further provided with an terminal electrode formed on a face of the multilayered component adjacent to the mounting-surface, and the isolated electrode is electrically connected to the terminal electrode via a viahole conductor and an inner conductor film formed inside of the multilayered component.

The isolated electrode may be a ground terminal electrode. In this case, the isolated electrode can be also used as a ground terminal electrode, which enhances the ground performance of the surface mounting component and provides stable characteristics.

Furthermore, according to the present invention, there is provided a mounted structure of a surface mounting component including the above described surface mounting component. The bonding strength of the surface mounting component to the mounting board is enhanced, since the isolated electrode is soldered to the mounting board.

### BRIEF DESCRIPTION OF THE DRAWINGS

FIG. 1 A illustrates the back-side face of a multilayered component according to a first embodiment of the present invention;
FIG. 1B is a cross section showing the state in which the multilayered component is surface-mounted;
FIG. 2 illustrates the back-side face of a multilayered component according to a second embodiment of the present invention;
FIG. 3 illustrates the back-side face of a multilayered component according to a third embodiment of the present invention;
FIG. 4 illustrates the back-side face of a multilayered component according to a fourth embodiment of the present invention;
FIG. 5 illustrates the back-side face of a multilayered component according to a fifth embodiment of the present invention;
FIG. 6 illustrates the back-side face of a multilayered component by a first conventional technique which is relevant to the present invention; and
FIG. 7 illustrates the back-side face of a multilayered component by a second conventional technique which is relevant to the present invention.

### DESCRIPTION OF THE PREFERRED EMBODIMENTS

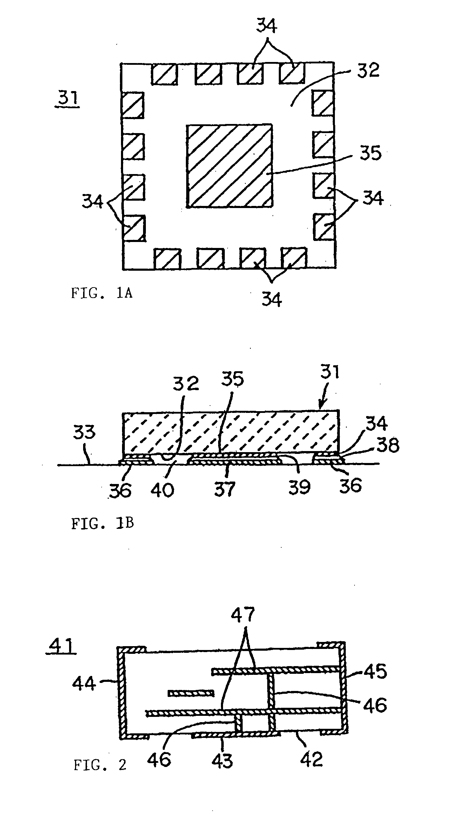

FIGS. 1A and 1B shows a multilayered component 31 as a surface mounting component according to a first embodiment of the present invention. FIG. 1A shows the back-side face of the multilayered component 31, namely, a mounting-surface 32. FIG. 1B shows, in cross section, the multilayered component 31 surface-mounted onto a motherboard 33. In FIG. 1B, the inner structure of the multilayered component 31 is not shown.

As shown in FIG. 1A, plural terminal electrodes 34 are arranged on the periphery of the mounting-surface 32 of the multilayered component 31. The terminal electrodes 34 may be provided with extensions which are extended onto the faces adjacent to the mounting-surface 32.

Moreover, an isolated electrode 35 is formed in the center of the mounting-surface 32 and arranged within the periphery of the mounting-surface 32 so as to be isolated from the respective terminal electrodes 34 in the mounting-surface 32. The isolated electrode 35 has a quadrangular shape in the embodiment shown in FIG. 1A, but it may take an optional shape.

Conductive lands 36 corresponding to the respective terminal electrodes 34 and a conductive land 37 corresponding to the isolated electrode 35 are formed on the motherboard 33, as shown in FIG. 1B. For the multilayered component 31, the terminal electrodes 34 are soldered to the conductive lands 36 by means of solder 38, respectively, with the mounting-surface 32 being faced to the motherboard 33. Moreover, the isolated electrode 35 is soldered to the conductive land 37 by means of solder 39. Thus, the multilayered component 31 is surface-mounted to the motherboard 33.

The isolated electrode 35 and the respective terminal electrodes 34 are kept sufficiently distant from each other. Therefore, the above-mentioned solders 38 and 39, when they are applied, can be prevented from flowing into and filling gaps 40 between the isolated electrode 35 and the terminal electrodes 34.

The isolated electrode 35 is bonded to the conductive land 37 on the motherboard 33 by means of the solder 39. This contributes to the increased bonding strength of the multilayered component 31 mounted to the motherboard 33.

The isolated electrode 35 may be provided exclusively for enhancement of the bonding strength, not electrically utilized, in the multilayered component 31, or may also function as at least a part of the terminal electrodes provided for electrical use as ground terminal electrodes or the like.

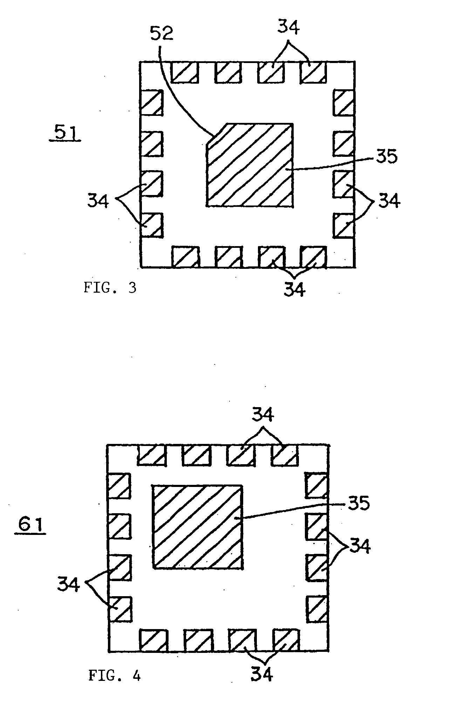

FIG. 2 is a cross section schematically showing a multilayered component 41 according to a second embodiment of the present invention.

In the multilayered component 41, an isolated electrode 43 is formed on a mounting-surface 42, and moreover, plural terminal electrodes 44 and 45 are formed on the faces adjacent to the mounting-surface 42. The terminal electrodes 44 and 45 each have extensions which are extended onto the mounting-surface 42 and a part of the face opposite to the mounting-surface 42.

Some viaholes 46 and some inner conductor films 47 are formed inside of the multilayered component 41. The isolated electrode 43 is electrically connected particularly to the terminal electrode 45 via the viaholes 46 and the inner conductor films 47.

In the multilayered component 41, when the terminal electrode 45 is used as a ground terminal electrode, the isolated electrode 43 can be also used as the ground terminal electrode. Accordingly, the grounding performance of the multilayered component 41 is enhanced, and thereby, stable characteristics can be obtained.

FIGS. 3 and 4 illustrate the back-side faces of multilayered components 51 and 61 according to third and fourth embodiments of the present invention, respectively. The multilayered components 51 and 61 of FIGS. 3 and 4 are provided with many elements similar to those of the multilayered component 31 of FIG. 1. In FIGS. 3 and 4, elements corresponding to those shown in FIG. 1 are designated by the same reference numerals, and the repeated description is omitted.

The multilayered component 51 shown in FIG. 3 is characteristic in the shape of an isolated electrode 35. The shape of the isolated electrode 35, provided with a cutting 52, is unsymmetrical.

The multilayered component 61 shown in FIG. 4 is characteristic in the position of an isolated electrode 35. That is, the isolated electrode 35 is positioned so as to be unsymmetrical with respect to the mounting-surface 32.

In the above-described multilayered components 51 and 61, a directional discriminating function can be rendered to each isolated electrode 35. Thereby, an error in directing, which may occur when the multilayered components 51 and 61 are mounted, can be eliminated easily, before hand.

FIG. 5 illustrates the back-side face of a multilayered component 71 according to a fifth embodiment of the present invention.

In the multilayered component 71, plural terminal electrodes 73 are formed in the periphery of a mounting-surface 72, and also, two isolated electrodes 74 and 75 are arranged in parallel to each other, in the center of the mounting-surface 72 so as to be isolated from the respective terminal electrodes 73. As seen in this embodiment, the number of isolated electrodes may be optionally changed.

Heretofore, the present invention has been described in respect to the multilayered components mounted onto the motherboards, respectively. The present invention, not limited to the multilayered components, can be applied to any surface mounting component, provided that the component is surface-mounted onto an appropriate mounting board by soldering.

As described above, according to the present invention, the isolated electrode is arranged on the mounting-surface of the surface mounting component so as to be isolated from other terminals on the mounting-surface. By soldering the isolated electrode to a mounting board, the bonding strength of the mounted surface mounting component to the mounting-surface can be enhanced, and also, for the solder applied to the isolated electrode, the application range can be securely limited to an area within the isolated electrode.

Accordingly, it becomes unnecessary to form solder resist films or slits, which has been conventionally conducted. Thus, troubles caused by the formation of the solder resist films or the slits can be eliminated.

By providing an unsymmetrical shape for the isolated electrode or positioning the isolated electrode unsymmetrically with respect to the mounting-surface, a directional discriminating function can be rendered to the isolated electrode. Accordingly, the possibility that directional errors are caused at mounting of the surface mounting component can be reduced, by utilization of the function.

Preferably, the surface mounting component of the present invention is a multilayered component, the multilayered component is further provided with a terminal electrode formed on a face of the multilayered component adjacent to the mounting-face, and the isolated electrode is electrically conducted to the terminal electrode via a viahole conductor and an inner conductor film. Accordingly, the isolated electrode can be electrically utilized in addition to its use for enhancement of the bonding strength as described above. In the case in which the above-described terminal electrode is a ground terminal electrodes, the grounding performance of the multilayered component is enhanced. Thus, stable characteristics can be rendered.

## Claims

1. A surface mounting component (31; 41; 51; 61; 71) to be surface-mounted onto a mounting board (33) by soldering, comprising:
an isolated electrode (35; 43; 74, 75) to be soldered to the mounting board (33), arranged on a mounting-surface (32; 42; 72) of the surface mounting component (31; 41) so as to be isolated from other terminal electrodes (34; 45; 73),
**characterized in that**
the terminal electrodes (34; 45; 73) are arranged so as to surround the isolated electrode (35; 43; 74, 75) on the mounting-surface (32; 42; 72), and
the isolated electrode (35) per se takes an unsymmetrical shape to have a directional discriminating function or is provided unsymmetrically with respect to the mounting-surface (32) to have a directional discriminating function.

2. A surface mounting component (31; 41; 51; 61; 71) according to claim 1, wherein the surface mounting component (41) is a multilayered component (41), the multilayered component (41) is further provided with a terminal electrode (45) formed on a face of the multilayered component (41) adjacent to the mounting-surface (42), and the single isolated electrode (43) is electrically connected to the terminal electrode (45) via a viahole conductor (46) and an inner conductor film (47) formed inside of the multilayered component (41).

3. A surface mounting component (31; 41; 51; 61; 71) according to claim 1 or 2, wherein the single isolated electrode (35; 43; 74, 75) is a ground terminal electrode.

4. A mounted structure of a surface mounting component comprising the surface mounting component (31; 41; 51; 61; 71) according to any one of claims 1 to 3 soldered to a mounting board (33).
